# EUROPÄISCHE PATENTANMELDUNG

(11) **EP 1 881 752 A1**
(43) Veröffentlichungstag der Anmeldung: **23.01.2008**
(21) Anmeldenummer: 06014844.2
(22) Anmeldetag: 17.07.2006
(51) Int. Cl.: H05K 5/00

(54) **Gehäuse zur Aufnahme elektrischer Komponenten**

(71) Anmelder: SIEMENS AKTIENGESELLSCHAFT, 80333 München (DE)
(72) Erfinder: Puri, Werner, Dr., 90429 Nürnberg (DE); Seidl, Joachim, 92237 Sulzbach-Rosenberg (DE)

(57) **Zusammenfassung**

Die Erfindung betrifft ein Gehäuse zur Aufnahme elektrischer Komponenten mit einem Gehäuseunterteil, mit einer Leiterzuführungsöffnung und mit einem Gehäusedeckel zur Abdeckung des Gehäuseunterteils. Das Gehäuse soll bei vorteilhafter Bauteilreduktion die Möglichkeit einer sehr komfortablen Montage und Demontage bieten. Die Leiterzuführungsöffnung ist dazu vorgesehen, im geschlossenen Zustand des Gehäuses vom Gehäuseunterteil und vom Gehäusedeckel begrenzt zu werden. Hierdurch entfällt der mühsame Einfädelvorgang bei einer Kabelinstallation an einer elektrischen Komponente im Inneren des Gehäuses. Zusätzlich ist der Leiterzuführungsöffnung begrenzende Gehäusedeckel mit ersten Führungselementen versehen, die zum Eingriff in das Gehäuseunterteil vorgesehen sind.

## Beschreibung

Die Erfindung betrifft ein Gehäuse zur Aufnahme elektrischer Komponenten mit einem Gehäuseunterteil, mit einer Leiterzuführungsöffnung und mit einem Gehäusedeckel zur Abdeckung des Gehäuseunterteils. Die Erfindung betrifft weiter einen Gehäusedeckel sowie ein Gehäuseunterteil für ein derartiges Gehäuse.

Ein derartiges Gehäuse kommt immer dann zum Einsatz, wenn elektrische Komponenten von der Außenwelt abgeschirmt bzw. geschützt werden müssen. Der Einsatz eines derartigen Gehäuses ist beispielsweise in der Installationstechnik, Sicherheitstechnik, Automatisierungstechnik, Anschlusstechnik und Messtechnik denkbar.

In Abhängigkeit von der Anwendung weist das Gehäuse Dichtungsmöglichkeiten auf, die durch die Anfälligkeit der elektrischen Komponenten bestimmt wird. Je nach Schutzklasse kann das Gehäuse zum Schutz vor Feuchtigkeit, Spritzwasser oder mechanischer Beanspruchung vorgesehen sein.

Eine weitere Funktion des Gehäuses besteht darin, dass die Leiter, wie zum Beispiel Kabel, den elektrischen Komponenten in der erforderlichen Anzahl zuführbar sind. Die Leiterzuführungsöffnung vergrößert die Komplexität des Dichtungsproblems. Andererseits ist für die Montage ein leicht zugängliches Gehäuse bzw. Gehäuseteil von Vorteil. Folglich ergibt sich das Design eines derartigen Gehäuses aus einem Kompromiss zwischen Montagefreundlichkeit und Dichtungsproblematik.

Ein derartiges Gehäuse wird auch im Zusammenhang mit Positions- und Sicherheitsschaltern verwendet. Positionsschalter müssen ebenfalls an elektrische Leiter angeschlossen werden. Dies geschieht beispielsweise direkt oder indirekt über ASI-Steckverbinder (Aktor-Sensor-Interface Steckverbinder), die an die elektrischen Komponenten, wie zum Beispiel ein Schaltelement, angeschlossen werden. Das Positionsschaltergehäuse weist in der Regel eine oder mehrere Anschlussöffnungen sowie einen Deckel auf.

Der Deckel wird beim Anschließen der Leiter abgenommen, um diese am Schaltelement anzuschließen, nachdem diese durch die Leiteröffnungen eingefädelt wurden. Die Leiterzuführungsöffnungen werden auch als Anschlussöffnungen bezeichnet und sind in der Regel als standardisierte Schnittstelle zwischen dem Gehäuse und der Installationsumgebung realisiert. Die standardisierte Schnittstelle kann hierbei als Leiterverschraubung, Stecker oder ähnlichem.

Nicht nur das Gehäuse bzw. dessen Bestandteile, sondern auch die Anschlussöffnungen müssen mehrere Voraussetzungen erfüllen. Sie müssen den Geräteinnenraum gegen Eindringen von Fremdkörpern und Flüssigkeiten, sowie gegen andere Umwelteinflüsse schützen. Die Dichtigkeit des Gehäuses muss des Weiteren nationalen und internationalen Normen entsprechen. Zudem ist in der Regel eine leichte Montierbarkeit der Anschlussleistungen erwünscht.

Aus DE 36 29 783 C2 ist ein Verschluss für ein Gehäuse mit einem an einem Grundteil mittels Schnappverbindung festlegbaren Deckelteil bekannt. Das in der erwähnten Patentschrift offengelegte Gehäuse ist an seiner oberen Öffnungsseite über das Deckelteil hermetisch dicht verschließbar. Zusätzlich weist das Gehäuse eine separate Leiterzuführungsöffnung auf.

Die Aufgabe der Erfindung besteht darin, ein Gehäuse mit den Merkmalen des Oberbegriffs des Anspruchs 1 dahingehend weiterzubilden, dass es hohe Sicherungsanforderungen bezüglich Schließ- und Dichtungsfunktionen erfüllt und dennoch montage- und demontagefreundlich ist.

Diese Aufgabe wird durch ein Gehäuse der eingangs genannten Art dadurch gelöst, dass die Leiterzuführungsöffnung im geschlossenen Zustand des Gehäuses vom Gehäuseunterteil und vom Gehäusedeckel begrenzt ist, wobei an dem Gehäusedeckel mindestens ein erstes Führungselement angeformt ist, welches zum Eingriff mit mindestens einem, am Gehäuseunterteil angeordneten, zweiten Führungselement vorgesehen ist.

Der Erfindung liegt die Erkenntnis zugrunde, dass das Einfädeln der Anschlussleitungen bzw. der Leiter zu einer Montageraumreduktion und somit zu Handlingproblemen führt. Bei Anschluss mehrerer Leitungen kann dies unter Umständen zu Bauraumproblemen führen und eine nachteilige Einklemmgefahr hervorrufen.

Beim erfindungsgemäßen Gehäuse zur Aufnahme elektrischer Komponenten ist die Leiterzuführungsöffnung, die am Gehäuseunterteil angeordnet ist, im geschlossenen Zustand des Gehäuses sowohl vom Gehäuseunterteil, als auch vom Gehäusedeckel begrenzt. Der offene Zustand des Gehäuses entspricht hierbei dem Zustand bei der Montage der Leiter, insbesondere Kabel. Hierbei ist es unerheblich, ob ein Leiter zuerst an einer elektrischen Komponente fixiert und anschließend in der Leiterzuführungsöffnung platziert wird oder umgekehrt. Dies macht einen vorteilhaften Montage-/Demontagekomfort aus. Erfindungsgemäß bilden die Leiterzuführungsöffnung und die Öffnung des Gehäuseunterteils, die vom Gehäusedeckel abgedeckt wird, eine einzige Öffnung. Im geschlossenen Zustand deckt der Gehäusedeckel die von ihm abzudeckende Öffnung ab und begrenzt gleichzeitig zusammen mit dem Gehäuseunterteil die Leiterzuführungsöffnung. Des Weiteren ist mindestens ein erstes Führungselement angeformt, welches zum Eingriff mit mindestens einem am Gehäuseunterteil angeformten zweiten Führungselement vorgesehen ist. Der Gehäusedeckel kombiniert somit mehrere Funktionen. Eine erste Funktion besteht darin, das Gehäuseunterteil sicher abzudecken. Eine zweite Funktion besteht darin, die Leiterzuführungsöffnung zumindest teilweise zu begrenzen und eine dritte Funktion, eine vorteilhafte Kraftwirkung zur optimalen Dichtung bereitzustellen.

Vorteilhafterweise ermöglicht das erfindungsgemäße Gehäuse eine flexible Montage in der Art, dass eine Verbindung des Leiters mit einer elektrischen Komponente und eine Positionierung des oder der Leiter in der Leiterzuführungsöffnung unabhängig voneinander erfolgen kann. Insbesondere ist die Reihenfolge der beiden Aktionen nicht maßgebend. Dies bedeutet, dass die elektrische Komponente, beispielsweise eine Schalteinheit, an den Leiter anschließbar ist und nach dem elektrischen Anschluß im Gehäuse installiert werden kann. Damit ist das Gehäuse einfach auswechselbar und/oder vorinstallierbar ohne eine elektrische Verbindung zwischen den Leitern und der elektrischen Komponente unterbrechen bzw. erneut herstellen zu müssen. Vorteilhafterweise sind hierdurch mechanische und elektrische Installation zeitlich voneinander trennbar, wodurch der Personalaufwand gegebenenfalls vorteilhaft einteilbar ist.

Als vorteilig erweist sich ebenfalls die geringe Bauteilanzahl des erfindungsgemäßen Gehäuses, die im Wesentlichen durch eine Mehrfachfunktion des Gehäusedeckels verursacht wird. Es ist kein weiteres Bauteil zum Befestigen des Leiters notwendig. Durch eine formgenaue Begrenzung der Leiterzuführungsöffnung durch den Gehäusedeckel ist es möglich, bei einer beispielsweise kreisförmig ausgeführten Leiterzuführungsöffnung ein Gewinde vorzusehen, obwohl der angrenzende Gehäusedeckel ein bewegbares Bauteil darstellt. Dadurch wird nicht nur die Anzahl der Bauteile reduziert, sondern das Design ist zudem sehr einfach ausführbar.

Bei einer vorteilhaften Ausführungsform wird die Festigkeit des Anschlussbereiches gegenüber Biegemomentbelastungen durch den formschlüssigen Eingriff von mindestens einem ersten Führungselement am Gehäusedeckel und mindestens einem zweiten Führungselement am Gehäuseunterteil verbessert. Durch die Nähe der Führungselemente zur Leiterzuführungsöffnung kann eine Rotationsachse zum Öffnen und Schließen des Gehäusedeckels derartig vorgegeben werden, dass eine Hebelwirkung auf die in der Leiterzuführungsöffnung angeordneten Leiter ausgeübt wird. Diese Hebelwirkung führt zu einer Klemmung der Leiter in der Leiterzuführungsöffnung und damit zu einer Entlastung des elektrischen Anschlusses der elektrischen Komponente bzw. Komponenten von leiterseitigen, insbesondere kabelseitigen, schädlichen Zugkräften.

Bei einer vorteilhaften Ausführungsform weisen die ersten Führungselemente des Gehäusedeckels und/oder die zweiten Führungselemente des Gehäuseunterteils eine oder mehrere Spannflächen auf, die mittels einer keilähnlichen Anformung an das jeweilige Führungselement bei der Rotationsbewegung des Gehäusedeckels eine Leiterzuführungsöffnung verengende Wirkung erzielen. Hierbei werden die zweiten Führungselemente des Gehäuseunterteils geringfügig aufeinander zu bewegt und das Gehäuseunterteil elastisch beansprucht. Aufgrund dieses weiteren Mechanismus sind die Leiter durch die Schließbewegung des Gehäusedeckels zusätzlich mittels einer kleinen Verkleinerung der Gehäuseöffnung klemmbar, womit eine Zugentlastung im geschlossenen Zustand des Gehäuses herbeigeführt wird. Zusätzlich wird die Dichtung der Leiterzuführungsöffnung unterstützt.

Bei einer vorteilhaften Ausführungsform weist der Gehäusedeckel ein erstes angeformtes Dichtungselement zur Komplettierung einer dichtungsrelevanten Formgebung der Leiterzuführungsöffnung auf. Durch das angeformte Dichtungselement wird die Festigkeit des Anschlussbereiches, insbesondere des Bereiches um die Leiterzuführungsöffnung, intensiviert. Vorteilhafterweise kann das angeformte Dichtungselement zur Formgebung bzw. Begrenzung der Leiterzuführungsöffnung durch den Gehäusedeckel eingesetzt werden. Ebenso ist die Kraftwirkung auf den oder die Leiter durch das angeformte Dichtungselement, insbesondere durch dessen Länge, kontrollierbar.

Vorteilhafterweise weist der Gehäusedeckel ein zweites Dichtungselement zur Dichtung der Leiterzuführungsöffnung auf, welches einstückig mit einer Dichtung der abdeckbaren Öffnung verbunden ist. Das zweite Dichtungselement und die Dichtung des Deckels sind elastische Dichtungselemente, wobei das zweite Dichtungselement zur Dichtung der Leiterzuführungsöffnung und die Dichtung zur elastischen Dichtung der abdeckbaren Öffnung vorgesehen ist. Durch die einstückige Ausführung des zweiten Dichtungselements und der Dichtung wird nicht nur die Bauanteilzahl reduziert, sondern es sind auch bei der Herstellung beide Elemente in einem Arbeitsgang herstellbar. Die Herstellung kann beispielsweise durch das Einspritzen eines thermoplastischen Elastomers oder eines anderen Weichkomponenten erzielt werden.

Weitere vorteilhafte Ausbildungen und bevorzugte Weiterbildungen der Erfindung sind der Figurenbeschreibung und/oder den Unteransprüchen zu entnehmen.

Im Folgenden wird die Erfindung anhand der in den Figuren dargestellten Ausführungsbeispiele näher beschrieben und erläutert.

Es zeigen:
- FIG 1: eine perspektivische Ansicht eines Ausführungsbeispiels eines Gehäuseunterteils eines Gehäuses,
- FIG 2: eine perspektivische Ansicht eines Ausführungsbeispiels eines Gehäusedeckels für das in der Figur 1 dargestellte Gehäuseunterteil,
- FIG 3: eine perspektivische Ansicht des Gehäusedeckels aus Figur 2 mit Dichtung,
- FIG 4: eine Ansicht des Gehäusedeckels aus Figur 2,
- FIG 5: eine perspektivische Ansicht der Gehäuseteile aus den Figuren 1 bis 4 in einem ersten Montageschritt und
- FIG 6: eine perspektivische Ansicht der Gehäuseteile aus den Figuren 1 bis 4 in einem zweiten Montageschritt.

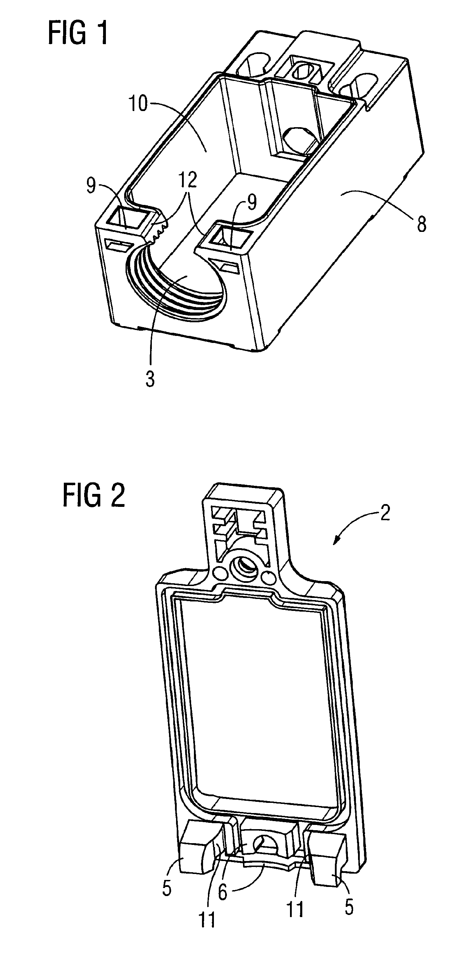

FIG 1 zeigt ein Gehäuseunterteil 8 mit einer Deckelöffnung 10 und einer Leiterzuführungsöffnung 3. Die Verbindung der beiden Öffnungen ermöglicht eine einfache Montage bzw. eine einfaches Einlegen von Kabeln in das Innere des Gehäuseunterteils 8.

In der Nähe der Leiterzuführungsöffnung 3 sind zwei zweite Führungselemente 9 angeformt. Die zweiten Führungselemente 9 ermöglichen ein Anschlagen und eine drehbare Führung erster Führungselemente 5 des Gehäusedeckels 2 (in Figuren 2,3 und 5 abgebildet). In vorteilhafter Weise sind die zweiten Führungselemente 9 mit jeweils einer Ausnehmung kombiniert, wobei die Bewegung der ersten Führungselemente 5 innerhalb des Gehäuseunterteils 8 berücksichtigt ist.

Die Größe der zweiten Führungselemente 9 kann mit Rücksicht auf die Breite der Verbindung der Deckelöffnung 10 und der Leiterzuführungsöffnung 3 ausgeführt werden. Die Verbindung der beiden Öffnungen kann auch für eine ganz bestimmte Kabel- bzw. Leiterdicke ausgelegt sein, so dass ein Leiter gerade noch einlegbar ist, allerdings durch die Präsenz der Verbindung in der Leiterzuführungsöffnung 3 gehalten werden kann. Ein ungewolltes Herausrutschen eines Kabels oder Leiters wird somit wirkungsvoll unterdrückt.

FIG 2 zeigt einen Gehäusedeckel 2 mit zwei ersten Führungselementen 5 zur Unterstützung der teilweisen Rotationsbewegung des Gehäusedeckels 2 bei Eingriff der ersten Führungselemente 5 in die zugehörigen zweiten Führungselemente 9 des Gehäuseunterteils 8.

Zusätzlich weist der Gehäusedeckel 2 zwei erste Dichtungselemente 6 auf, die zur Dichtung der Leiterzuführungsöffnung 3 vorgesehen sind. Die Anordnungen der beiden Dichtungselemente 6 und auch deren Formgebung unterstützt eine Verankerung eines zweiten Dichtungselementes 7 zur Dichtung der Leiterzuführungsöffnung 3. Die ersten angeformten Dichtungselemente 6 dienen weiterhin zur Druckübertragung bei geschlossenem Gehäusedeckel 2 auf die eingelegten Kabel bzw. Leiter.

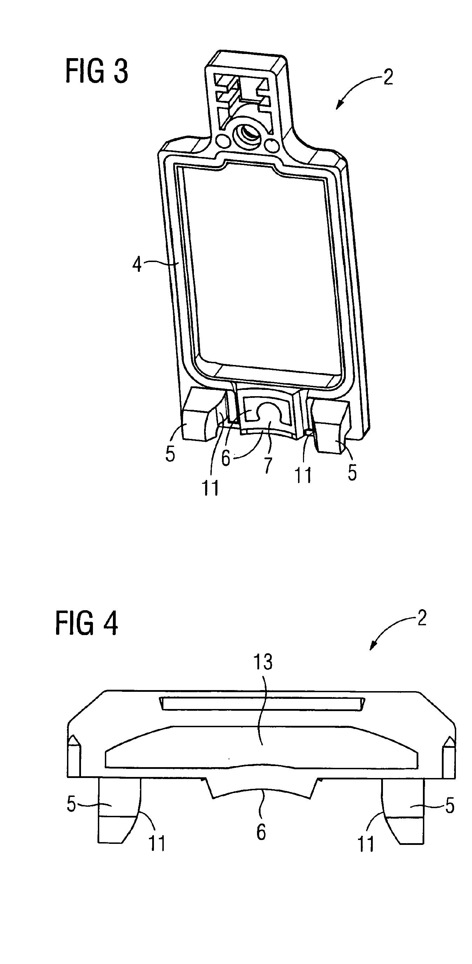

FIG 3 zeigt einen Gehäusedeckel mit Dichtung 4. Zur Abdichtung werden eine Dichtung 4 der Deckelöffnung 10 und ein zweites Dichtungselement 7 verwendet. Beide Dichtungselemente 4,7 können bei einem aus Kunststoff hergestellten Gehäusedeckel 2 mit einem Weichkomponent (thermoplastisches Elastomer) realisiert werden. Ein derartiger Werkstoff kann auf einfache Weise eingespritzt werden und kann außerdem eine Formgebung des zweiten Dichtungselementes 7 vorteilhaft unterstützen. So kann das zweite Dichtungselement 7 zur optimalen elastischen-Abdichtung der Leiterzuführungsöffnung 3 dienen. So ist beispielsweise eine flache, gekrümmte oder mit einem Gewinde versehene Oberfläche des zweiten Dichtungselementes 7 möglich.

In einer besonders einfachen Ausführungsform können die ersten Dichtungselemente 6 im zweiten Dichtungselement 7 derartig versenkt sein, dass eine Dichtung der Leiterzuführungsöffnung 3 lediglich durch das zweite Dichtungselement 7 bewerkstelligt wird.

FIG 4 zeigt eine Ansicht des Gehäusedeckels 2 aus FIG 2, bei welchem eine Ausnehmung 13 an der Hinterseite des Gehäusedeckels 2 vorgesehen ist. Diese Hinterseite ist die Seite des Gehäusedeckels, die den Leitern bzw. der Leiteranschlussvorrichtung und/oder einer Dichtungsvorrichtung zugewandt ist. Die Ausnehmung verhindert auf elegante Weise eine Verkeilung des Gehäusedeckels 2, der auch bei installierten Leitern operabel, d.h. rotierbar bleibt.

Weiter sind Spannflächen 11 vorgesehen, die beim Schließvorgang ein Zusammenziehen der zweiten Führungselemente 9 und somit der Leiterdurchführungsöffnung erzielen. Dies führt zu einer effektiven Zugentlastung der Leiter, insbesondere Kabel. Zudem wird durch das Zusammenwirken mit der Dichtungskante 12 eine effektive Dichtung des Gehäuses erzielt.

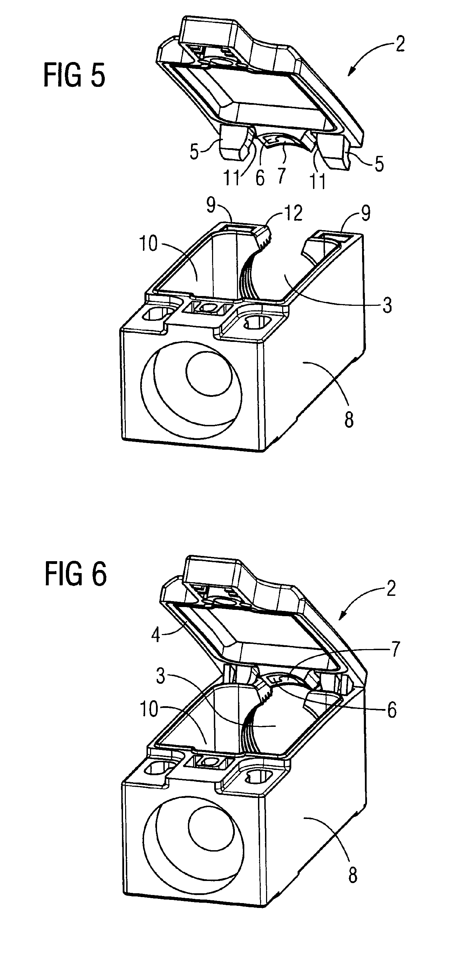

FIG 5 zeigt ein Gehäuse in einem ersten Montageschritt. Das Gehäuse besteht im Wesentlichen aus dem Gehäuseunterteil 8 und dem Gehäusedeckel 2. Beide Bauteile befinden sich jeweils in einer Position zueinander, die einem ersten Montageschritt entspricht. Zur Einfädelung des Gehäusedeckels 2 ist eine Translation in Richtung der Deckelöffnung 10 und eine anschließende Rotationsbewegung notwendig. Nach der Rotationsbewegung deckt der Gehäusedeckel 2 die Deckelöffnung 10 des Gehäuseunterteils 8 ab.

Vorteilhafterweise ist der Gehäusedeckel 2 im geschlossenen Zustand mit einer Schraube an das Gehäuseunterteil 8 fixierbar. Die ersten Führungselemente 5 unterstützen den Fixierungsprozess in der Art, dass lediglich eine Schraube ausreicht, die Fixierung durchzuführen.

Im abgedeckten Zustand (Deckelöffnung 10 abgedeckt) ist die Leiterzuführungsöffnung 3 in ihrer Geometrie vervollständigt. Vorteilhafterweise weist die Leiterzuführungsöffnung 3 ein Innengewinde auf, das als Teil einer standardisierten Schnittstelle zwischen dem Gehäuse und der Installationsumgebung dient. Hierbei ist kein zusätzliches Adapterteil notwendig. Der standardisierte Stecker oder Leiterverschraubung kann direkt am Gehäuse erfolgen.

Als vorteilhaft erweisen sich die Spannflächen 11, die bei der Schließbewegung des Gehäusedeckels 2 die zweiten Führungselemente 9 aufeinander zu bewegen und somit mittels elastischer Beanspruchung des Gehäuseunterteils 8 eine Verengung der Leiterdurchführungsöffnung 3 und eventuell eine Klemmung der darin befindlichen Leiter (nicht abgebildet) erzielen. Der Grad der Verengung ist hierbei über eine entsprechende Anformung der Spannflächen 11 bzw. mittels eines entsprechenden Spannwinkels definierbar.

FIG 6 zeigt das Gehäuse in einem zweiten Montageschritt. Die ersten und zweiten Führungselemente 5, 9 greifen bei dem zweiten Montageschritt ineinander und ermöglichen eine teilweise Rotationsbewegung mit einer Rotationsachse, die nahe bei der Leiterzuführungsöffnung 3 angeordnet ist. Nach der teilweisen Rotationsbewegung des Gehäusedeckels 2 befindet sich das Gehäuse im geschlossenen Zustand. In dieser Ansicht wird nochmals deutlich, dass kein zusätzliches Dichtteil, sondern lediglich beispielsweise ein Kabelverschraubungsdichtring zur Abdichtung notwendig ist. Das als flächenweises Weichkomponent ausgeführte zweite Dichtungsteil 7 ermöglicht neben der bereits erwähnten Vereinfachung zusätzlich eine Druckfläche auf dem Kabelverschraubungsdichtring bzw. auf den oder die Leiter. Die Festigkeit des Anschlussbereiches wird durch die erzielte Hebelwirkung durch den Gehäusedeckel 2 bzw. dessen Rotationsbewegung in Richtung des Gehäuseunterteils 8 erreicht und somit eine effektive Zugentlastung der mechanischen Verbindung der Leiter mit elektrischen Komponenten (nicht gezeigt) innerhalb des Gehäuseunterteils 8 realisiert.

Der vom ersten und zweiten Dichtungselement 6, 7 abgedeckte Bereich definiert in Bezug auf den Mittelpunkt der Leiterzuführungsöffnung 3 einen Öffnungswinkel der Leiterzuführungsöffnung 3. Dieser Öffnungswinkel kann bis zu 180° betragen. Allerdings sind Öffnungswinkel von Vorteil, die kleiner als 180° sind. Dadurch wird gewährleistet, dass im offenen Zustand ein eingelegtes Kabel innerhalb der Leiterzuführungsöffnung 3 gehalten werden kann. Außerdem ist der Dichtungsaufwand bei kleineren Öffnungswinkeln geringer. Es ist allerdings jeder Winkel zwischen 0° und 180° denkbar, beispielsweise 10°, 30°, 50° oder 70°.

Zusammenfassend betrifft die Erfindung ein Gehäuse zur Aufnahme elektrischer Komponenten mit einem Gehäuseunterteil, mit einer Leiterzuführungsöffnung und mit einem Gehäusedeckel zur Abdeckung des Gehäuseunterteils. Das Gehäuse soll bei vorteilhafter Bauteilreduktion die Möglichkeit einer sehr komfortablen Montage und Demontage bieten. Die Leiterzuführungsöffnung ist dazu vorgesehen, im geschlossenen Zustand des Gehäuses vom Gehäuseunterteil und vom Gehäusedeckel begrenzt zu werden. Hierdurch entfällt der mühsame Einfädelvorgang bei einer Kabelinstallation an einer elektrischen Komponente im Inneren des Gehäuses. Zusätzlich ist der leiterzuführungsöffnungsbegrenzende Gehäusedeckel mit ersten angeformten Führungselementen versehen, die zum Eingriff in das Gehäuseunterteil vorgesehen sind.

## Patentansprüche

1. Gehäuse zur Aufnahme elektrischer Komponenten mit einem Gehäuseunterteil (8), mit einer Leiterzuführungsöffnung (3) und mit einem Gehäusedeckel (2) zur Abdeckung des Gehäuseunterteils (8), **dadurch gekennzeichnet, dass** die Leiterzuführungsöffnung (3) im geschlossenen Zustand des Gehäuses vom Gehäuseunterteil (8) und vom Gehäusedeckel (2) begrenzt ist, wobei an dem Gehäusedeckel (2) mindestens ein erstes Führungselement (5) angeformt ist, welches zum Eingriff mit mindestens einem im Gehäuseunterteil (8) angeordneten zweiten Führungselement (9) vorgesehen ist.

2. Gehäuse nach Anspruch 1, wobei das Gehäuseunterteil (8) zum Einlegen von mindestens einem Leiter, insbesondere Kabel, durch die im Bereich des Gehäusedeckels (2) im geöffneten Zustand nicht begrenzte Leiterzuführungsöffnung (3) vorgesehen ist.

3. Gehäuse nach einem der Ansprüche 1 oder 2, wobei der Gehäusedeckel (2) mindestens ein erstes Dichtungselement (6) zur Komplettierung einer Formgebung der Leiterzuführungsöffnung (3) aufweist.

4. Gehäuse nach einem der vorhergehenden Ansprüche, wobei der Gehäusedeckel (2) ein zweites Dichtungselement (7) zur zumindest teilweisen Dichtung der Leiterzuführungsöffnung (3) aufweist, welches einstückig mit einer Dichtung (4) des Gehäusedeckels (2) verbunden ist.

5. Gehäuse nach einem der vorhergehenden Ansprüche, wobei durch die ersten Führungselemente (5) eine Rotationsachse zum Öffnen und Schließen des Gehäusedeckels (2) vorgegeben ist.

6. Gehäuse nach Anspruch 5, wobei das erste und/oder zweite Dichtungselement (6, 7) in der Nähe der Rotationsachse angeordnet sind.

7. Gehäuse nach einem der vorhergehenden Ansprüche, wobei die Leiterzuführungsöffnung (3) ein Innengewinde aufweist.

8. Gehäusedeckel (2) zur Abdeckung eines Gehäuseunterteils (8) eines Gehäuses zur Aufnahme elektrischer Komponenten, wobei das Gehäuseunterteil (8) eine Leiterzuführungsöffnung (3) aufweist, **dadurch gekennzeichnet, dass** der Gehäusedeckel (2) zur Begrenzung der Leiterzuführungsöffnung (3) im geschlossenen Zustand des Gehäuses vorgesehen ist, wobei an dem Gehäusedeckel (2) mindestens ein erstes Führungselement (5) angeformt ist, welches zum Eingriff mit mindestens einem am Gehäuseunterteil (8) angeordneten zweiten Führungselement (9) vorgesehen ist.

9. Gehäusedeckel (2) nach Anspruch 8, wobei der Gehäusedeckel (2) ein erstes Dichtungselement (6) zur Komplettierung einer Formgebung der Leiterzuführungsöffnung (3) aufweist.

10. Gehäusedeckel (2) nach einem der Ansprüche 8 oder 9, wobei der Gehäusedeckel (2) mindestens ein zweites Dichtungselement (7) zur zumindest teilweisen Dichtung der Leiterzuführungsöffnung (3) aufweist, welches einstückig mit einer Dichtung (4) der Deckelöffnung (10) verbunden ist.

11. Gehäusedeckel (2) nach einem der Ansprüche 8 bis 10, wobei durch das erste Führungselement (5) eine Rotationsachse zum Öffnen und Schließen des Gehäusedeckels (2) vorgegeben ist.

12. Gehäusedeckel (2) nach Anspruch 11, wobei das erste und/oder zweite Dichtungselement (6, 7) in der Nähe der Rotationsachse anordenbar sind.

13. Gehäusedeckel (2) nach einem der Ansprüche 8 bis 12, wobei der Gehäusedeckel (2) Mittel zur Zugentlastung, insbesondere eine Spannfläche (11), aufweist.

14. Gehäuseunterteil (8) eines Gehäuses zur Aufnahme elektrischer Komponenten, wobei das Gehäuseunterteil (8) zur Abdeckung durch einen Gehäusedeckel (2) vorgesehen ist und eine Leiterzuführungsöffnung (3) aufweist, **dadurch gekennzeichnet, dass** die Leiterzuführungsöffnung (3) im geschlossenen Zustand des Gehäuses vom Gehäuseunterteil (8) und vom Gehäusedeckel (2) begrenzt ist, wobei zur Führung von mindestens einem ersten Führungselement (5) des Gehäusedeckels (2) im Gehäuseunterteil (8) mindestens ein zweites Führungselement (9) vorgesehen ist.

15. Gehäuseunterteil (8) nach Anspruch 14, wobei das Gehäuseunterteil (8) zum Einlegen von mindestens einem Leiter, insbesondere einem Kabel, durch die im geöffneten Zustand im Bereich des Gehäusedeckels (2) nicht begrenzte Leiterzuführungsöffnung (3) vorgesehen ist.

16. Gehäuseunterteil (8) nach einem der Ansprüche 14 oder 15, wobei die Leiterzuführungsöffnung (3) ein Innengewinde aufweist.

17. Schalter, insbesondere Positionsschalter, mit einem Gehäuseunterteil (8) nach einem der Ansprüche 14 bis 16 und/oder mit einem Gehäusedeckel (2) nach einem der Ansprüche 8 bis 13.
